Europäisches Patentamt

European Patent Office

Office européen des brevets

(19)

(11) Veröffentlichungsnummer: **0 337 007 B1**

(12) **EUROPÄISCHE PATENTSCHRIFT**

(45) Veröffentlichungstag der Patentschrift: **01.07.92**

(51) Int. Cl.⁵: **C23C 14/06**

(21) Anmeldenummer: **88114819.1**

(22) Anmeldetag: **09.09.88**

(54) **Hartstoff-Schutzschicht mit homogener Elementverteilung.**

(30) Priorität: **09.04.88 DE 3811907**

(43) Veröffentlichungstag der Anmeldung:
**18.10.89 Patentblatt 89/42**

(45) Bekanntmachung des Hinweises auf die
Patenterteilung:
**01.07.92 Patentblatt 92/27**

(84) Benannte Vertragsstaaten:
**AT CH FR GB IT LI SE**

(56) Entgegenhaltungen:
**EP-A- 0 229 522**
**US-A- 4 469 801**

**THIN SOLID FILMS, Band 162, August 1988,
Seiten 111-117, Elsevier Sequoia, Lausanne,
CH; W. POSADOWSKI: "Electric properties of
Ti-Si-N thin cermet films deposited in a triode sputtering system with a hot cathode"**

**THIN SOLID FILMS, Band 82, 1981, Seiten
313-320, Elsevier Sequoia, Lausanne, CH; G.
BEENSH-MARCHWICKA et al.: "Structure of
thin films prepared by the cosputtering of
titanium and aluminium or titanium and silicon"**

**WORLD PATENT INDEX, no. 77-13584Y/08; &
JP-A-52 003 197 (MATSUSHITA ELEC. IND.
K.K.) 14-01-1977**

(73) Patentinhaber: **KERNFORSCHUNGSZENTRUM
KARLSRUHE GMBH
Weberstrasse 5 Postfach 3640
W-7500 Karlsruhe 1(DE)**

(72) Erfinder: **Holleck, Helmut, Prof. Dr.
Im Eichbäumle 27
W-7500 Karlsruhe 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine einlagige oder mehrlagige, jeweils einphasige und vorwiegend kristalline, Titan enthaltende Hartstoff-Schutzschicht mit homogener Elementverteilung für Oberflächen von stark beanspruchten Werkstoff-Substraten und Verfahren zu ihrer Herstellung.

Der Schutz von Werkstoffen durch eine Oberflächenbehandlung oder Beschichtung gewinnt im Hinblick auf die besonderen Anforderungen neuer und fortentwickelter Technologien, z. B. bei Hochtemperaturwerkstoffen, und durch die Forderung nach verschleißärmeren Werkstoffen mit hoher Standzeit, z. B. für die spanabhebende Materialbearbeitung, zunehmende Bedeutung.

Bei der Hartstoffbeschichtung müssen viele, oft schwer gleichzeitig realisierbare Bedingungen berücksichtigt werden.

Die Problematik, das geeignete Hartstoff-Beschichtungsmaterial zu finden, beruht darauf, daß nicht alle Anforderungen mit einem einzigen Material zu realisieren sind und daß sich die geforderten Eigenschaften sogar teilweise ausschließen.

Eine wesentliche Rolle bei der Beschichtung von Werkstoffen spielen weiterhin die Konstitution des Materialsystems, die Herstellungsparameter und das Mikrogefüge.

Die Hartstoffe werden entsprechend ihrem unterschiedlichen Bindungsgefüge in drei Gruppen eingeteilt:

a) heteropolare Hartstoffe (Oxide von Aluminium, Zirkonium, Titan und Beryllium),

b) kovalente Hartstoffe (Boride, Carbide und Nitride von Aluminium, Silicium und Bor sowie Diamant),

c) metallische Hartstoffe (Boride, Carbide und Nitride der Übergangsmetalle).

Alle diese Hartstoffe schmelzen bei hohen Temperaturen.

Ihre übrigen Eigenschaften unterscheiden sich zum Teil beträchtlich.

Die heteropolaren Hartstoffe sind zwar thermodynamisch stabil und gehen geringe Wechselwirkungen mit anderen Materialien ein; sie sind jedoch spröde und weniger hart. Der thermische Ausdehnungskoeffizient ist höher als der der anderen Hartstoffe.

Die kovalenten Hartstoffe zeichnen sich durch hohe Härte, Oxidationsbeständigkeit, geringe Ausdehnungskoeffizienten und geringe Thermoschockempfindlichkeit aus. Besonders vorteilhaft ist der geringe Temperatureinfluß auf die mechanischen Eigenschaften.

Innerhalb dieser Gruppe weisen Siliciumcarbid (SiC) und Siliciumnitrid ($Si_3N_4$) besonders günstige Eigenschaften auf.

Der Verwendung als Schichtmaterial sind wegen des unzureichenden Haftvermögens der kovalenten Hartstoffe auf metallischen Substraten enge Grenzen gesetzt.

Die metallischen Hartstoffe bilden die vielseitigsten Schichtmaterialien.

Sie weisen wegen ihres hohen metallischen Bindungsanteils günstige Haftungseigenschaften auf. Sie sind weniger spröde als die übrigen Hartstoffe und besitzen eine hohe elektrische und Wärmeleitfähigkeit.

Ein charakteristischer Merkmal ist ihre häufig vollkommenene Mischbarkeit untereinander.

Eine Hartstoff-Schutzschicht muß eine Reihe von Bedingungen erfüllen, die sich z. T. sogar gegenseitig ausschließen.

So soll die Schicht auf dem Substrat möglichst gut haften; andererseits soll jedoch die Oberfläche der Beschichtung möglichst inert und oxidationsbeständig sein und mit anderen Materialien keine Wechselwirkung eingehen. Die Schicht soll möglichst hart, aber dennoch zäh und schlagunempfindlich sein. Weiterhin müssen die Temperaturkoeffizienten von Schicht und Substrat im selben Bereich liegen, damit die Schicht bei thermischer Beanspruchung nicht abplatzt. Die Eigenschaften der Schicht dürfen sich in Abhängigkeit von der Temperatur nicht stark ändern.

Bis jetzt wurde kein Material gefunden, das als Beschichtungsmaterial sämtliche Anforderungen erfüllt.

Deshalb werden z. Z. meist kompliziert aufgebaute, zusammengesetzte Hartstoff-Schutzschichten verwendet.

Mit den metallischen Hartstoffen können Gradientenschichten hergestellt werden, in denen sich die Zusammensetzung von der Substratoberfläche bis zur Schichtoberfläche kontinuierlich ändert. An das Substrat kann sich eine besonders haftfeste Schicht anschließen, während die Schichtoberfläche durch einen metallischen Hartstoff mit geringer Wechselwirkungstendenz und demzufolge geringer Adhäsion zu anderen Materialien besteht.

Hierdurch kann ein Teil der sich gegenseitig scheinbar ausschließenden Anforderungen realisiert werden.

Noch bessere Ergebnisse als mit Gradientenschichten werden nach der DE-PS 35 12 986 mit mehrphasigen bzw. Mehrlagenschichten erzielt. Solche Schichten können beispielsweise durch sequentielles Abstäuben von zwei verschiedenen Kathoden erzeugt werden.

Man kann hierbei ein Schichtmaterial mit guten Hafteigenschaften als erste Schicht wählen, eine Verbindung mit geringer Adhäsionsneigung als letztes, oberstes Material und durch günstige Konstitution der dazwischen liegenden Grenzflächen auch die Summe von Härte und Zähigkeit optimieren. Wesentlich ist die Ausbildung einer Vielzahl von Phasengrenzflächen zwischen den nanodispersiven Schichten.

Diese Phasengrenzflächen sind in der Lage, Energie aufzunehmen. Entstandene Risse werden an den Phasengrenzflächen seitlich abgelenkt, so daß die darunter liegenden Schichten geschützt werden.

Mehrphasige Mehrlagen- und Gradientenschichten müssen in ihrem Aufbau auf die Eigenschaften der zu beschichtenden Substrats exakt abgestimmt werden. Die Zahl der zu berücksichtigenden Parameter erhöht sich dadurch weiter. Ferner sind solche Beschichtungen aufwendig in der Herstellung und demzufolge teuer.

Aus der Veröffentlichung mit dem Titel "Structure of Thin Films Prepared by the Cosputtering of Titanium and Aluminium or Titanium and Silicon" von G. Beensh-Marchwicka et al, Thin Solid Films, 82 (1981) 313-320 ist ein reaktives Sputterverfahren bekannt, bei dem u. a. Doppeltargets aus Titan und Silicium (Oberflächenverhältnis 2:1) eingesetzt werden. Die Substrattemperatur beträgt 200 bis 250° C. Als Ergebnis dieses Verfahrens werden zweiphasige Schichten beschrieben, bei denen TiN-Kristalle in einer amorphen Ti-Si-N-Schicht eingebettet sind.

Der Erfindung liegt die Aufgabe zugrunde, eine harte und gleichzeitig zähe Schicht und ein Verfahren zu deren Herstellung anzugeben, mit der ein Werkstoff-Substrat gegen starke Beanspruchungen geschützt werden kann. Die Schicht soll gut auf dem Substrat haften, und eine harte, zähe, chemisch inerte, insbesondere oxidationsfeste Oberfläche aufweisen, die gegenüber anderen Materialien nicht zur Adhäsion neigt. Die Hartstoff-Schutzschicht soll gleichzeitig einfacher aufgebaut sein als die bekannten Mehrlagen- und Gradientenschichten und sich unter geringerem Aufwand und mit verminderten Kosten herstellen lassen.

Insbesondere sollen die besonders vorteilhaften Eigenschaften der kovalenten Hartstoffe $SiC$ und $Si_3N_4$ mit den günstigen Eigenschaften der metallischen Hartstoffe, insbesondere von TiC und TiN, in einem einzigen Schichtmaterial vereinigt werden.

Die Aufgabe wird erfindungsgemäß gelöst durch eine einlagige oder mehrlagige, jeweils einphasige und vorwiegend kristalline, Titan enthaltende Hartstoff-Schutzschicht mit homogener Elementverteilung für Oberflächen von stark beanspruchten Werkstoff-Substraten, die gekennzeichnet ist durch eine metastabile Mischphase aus mindestens einem metallischen Hartstoff und den kovalenten Hartstoffen Siliciumcarbid $(SiC)$ und/oder Siliciumnitrid $(Si_3N_4)$.

Als metallische Hartstoffe werden vorzugsweise TiN und/oder TiC eingesetzt.

Ein Verfahren zur Herstellung der erfindungsgemäßen Schutzschicht ist dadurch gekennzeichnet, daß die Schutzschicht durch Magnetron-Abstäuben in Argon-Atmosphäre und durch Abschrecken aus der Gasphase auf das Substrat aufgebracht wird, wobei eine Kathode mit der Zusammensetzung der Schutzschicht verwendet wird.

Die erfindungsgemäßen Schutzschicht kann jedoch auch in der Weise hergestellt werden, daß metallische Kathoden aufgestäubt werden und die Hartstoff-Schutzschicht durch eine reaktive Gasmischung auf dem Substrat gebildet wird, wobei die Temperatur des Substrats während der Beschichtung entsprechend der Höhe des Siliciumanteils zwischen 200 bis 1000° C gehalten wird.

Die weiteren Patentansprüche geben vorteilhafte Ausgestaltungen der Erfindung an.

Wegen der strukturellen und chemischen Unterschiede sind stabile kristalline Mischphasen zwischen den metallischen Hartstoffen TiN und TiC und den kovalenten Hartstoffen $SiC$ und $Si_3N_4$ nicht möglich.

Diese Hartstoffe weisen eine breite Mischungslücke auf. Silicium und Titan können unter normalen Bedingungen keine äquivalenten Gitterplätze einnehmen.

Theoretische Überlegungen zur Thermodynamik und Kinetik der Abscheidung mehrkomponentiger Schichten ergaben jedoch, daß z. B. in den Systemen $TiN-SiC$, $TiC-SiC$, $TiN-Si_3N_4$ und $TiCSi_3N_4$ Konzentrationsbereiche existieren müssen, in denen die Systemkomponenten im metastabilen Gleichgewicht vorliegen.

Diese metastabilen Bereiche weisen bei homogener Elementverteilung gegenüber den konkurrierenden Mischphasen (amorphe Phase, Mischphase vom Wurtzit-Typ, flüssige Phase) eine geringere Energie auf und sind dadurch stabilisiert, d. h. metastabil.

Solche stabilisierten Mischphasen lassen sich innerhalb bestimmter Konzentrationsbereiche durch Abschrecken der Komponenten aus der Gasphase erhalten.

Sie kristallisieren in einer einfachen Kristallstruktur, z. B. im kubisch-flächenzentrierten Kristallgitter, und weisen deshalb günstige mechanische Eigenschaften auf.

Die für die Ausbildung der erfindungsgemäßen Schichtstrvktur notwendige Beweglichkeit der Komponenten kann entweder durch gleichzeitigen Ionenbeschuß mit Argon-Ionen (Bias-Sputtern) oder durch günstige Wahl der Substrat-Temperatur, aber auch durch die Kombination beider Methoden erzielt werden.

EP 0 337 007 B1

Hierdurch läßt sich die Ausbildung vollständig amorpher Schichten wirksam verhindern.

Zwar sind Schutzschichten bekannt geworden, die aus TiN und AlN zusammengesetzt sind und die eine NaCl-Kristallstrvktur aufweisen (W.-D. Munz, J.Vac.Sci. Technol. A4 (6), Nov./Dec. 1986). Das Nitrid des Metalls Aluminium weist jedoch gegenüber dem Nitrid und Carbid des Halbmetalls Silicium ungünstigere Eigenschaften auf. Dies äußert sich insbesondere in der - gegenüber den erfindungsgemäßen Schutzschichten - geringeren Vickers-Härte von HV 2100 bis 2300.

Die Zusammenhänge sollen am Beispiel des Systems TiC-SiC verdeutlicht werden.

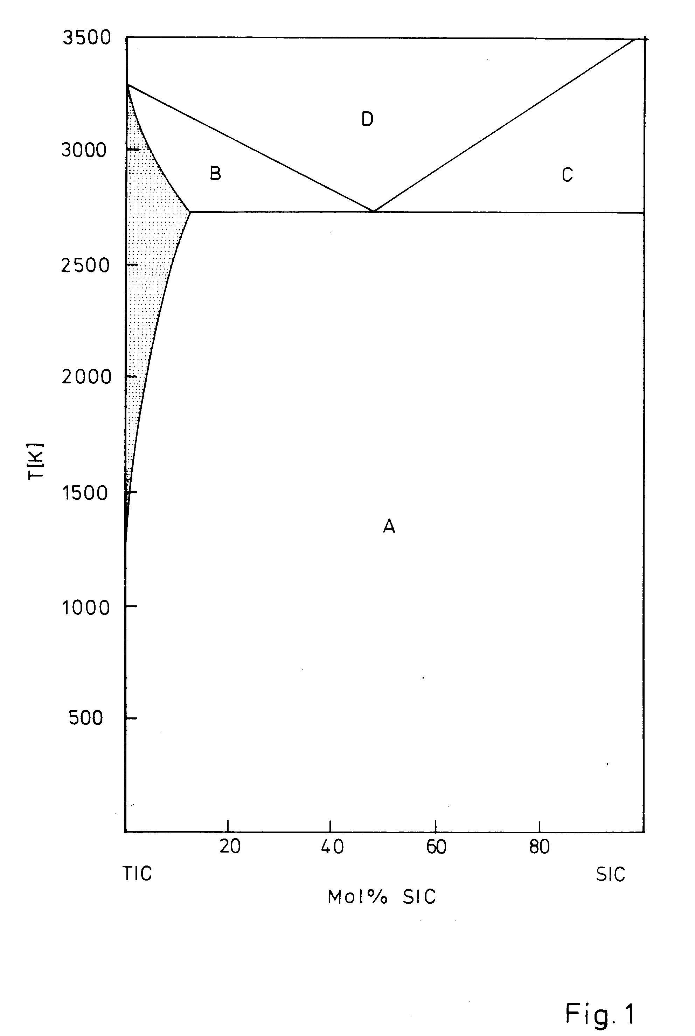

Fig. 1 zeigt das errechnete Zustandsdiagramm TiC-SiC im Gleichgewichtszustand. Dieses Zustandsdiagramm wurde durch Stichproben experimentell bestätigt. Da der normale zweiphasige Gleichgewichtszustand A (TiC + SiC) beim Abschrecken unter definierten Bedingungen aus der Gasphase nicht erreicht werden kann, geht das System in den am wenigsten instabilen Zustand mit homogener Elementverteilung über.

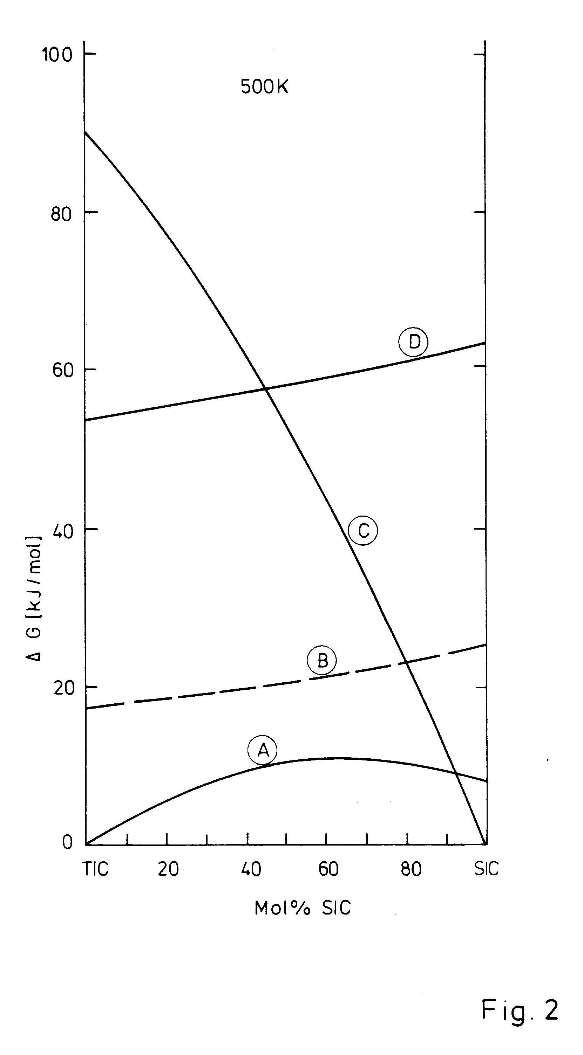

Fig. 2 zeigt die Freien Bildungsenthalpien (die ein Maß für die Stabilität einer Phase darstellen) von verschiedenen Mischphasen. Es zeigt sich, daß in einem Konzentratlonsbereich von >0 % SiC bis über 80 % SiC (Rest TiC) die kubisch flächenzentrierte Mischphase (Kurve A) weniger instabil ist als die anderen konkurrierenden Mischphasen (Kurve B: amorphe Phase, Kurve C: hexagonale Phase vom Zn0-Typ, Kurve D: flüssige Phase).

Den Rechnungen zufolge sollte es daher bei diesem System möglich sein, ein bisher noch nicht hergesteltes neuartiges Schichtmaterial z. B. der Zusammensetzung $(Ti_{0,5}Si_{0,5})C$ mit kubisch flächenzentrierter Struktur zu erhalten, das zwar gegenüber dem entmischten System TiC + SiC energetisch ungünstiger ist, jedoch gegenüber allen konkurrierenden Zuständen mit homogener Elementverteilung eine geringere Energie aufweist.

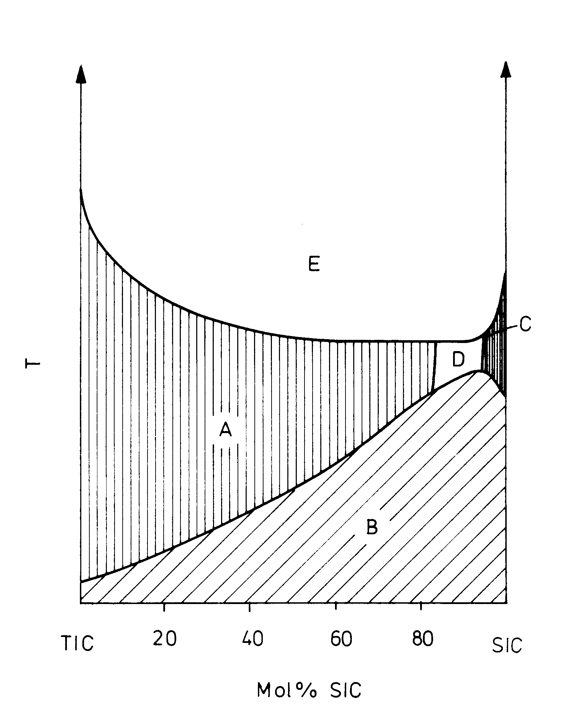

Fig. 3 zeigt schematisch den Temperatur- und Zusammensetzungsbereich (A), der die Herstellung dieser Mischphase ermöglicht. Die Abscheidetemperatur T kann in Abhängigkeit der Zusammensetzung so gewählt werden, daß sich die im System TiC-SiC erwünschte kubisch-flächenzentrierte Mischphase bildet.

Die Fläche B entspricht der amorphen Mischphase.

Aus Fig. 3 geht hervor, daß mit zunehmendem SiC-Anteil die Substrattemperatur T erhöht werden muß.

Bei einem SiC-Anteil von über 80 % SiC (Fläche D) bildet sich ein zweiphasiges System aus kubisch-flächenzentrierten und hexagonalen Kristallen und schließlich, bei noch höherem SiC-Anteil und entsprechender Temperatur (Fläche C), die hexagonale (Si,Ti)C-Mischphase.

Die Erfindung soll im folgenden anhand von Durchführungsbeispielen näher erläutert werden.

Die Kathoden wurden jeweils durch pulvermetallurgische Verfahren bei einem Druck von 26 MPa und einer Temperatur von 1800 bis 2100° C hergestellt.

Die Sinterzeit betrug 15 min.

Die Kathoden waren nach dieser Behandlung zweiphasig entsprechend dem Phasenfeld A in Fig. 1.

Beispiel 1

Durch Magnetronabstäuben von einer TiC/SiC-Kathode (hergestellt durch Heißpressen äquimolarer Anteile von SiC und TiC bei 2100° C) mit einer Gleichstrom-Flächenleistung von 11 W/cm$^2$, einer Schichtwachstumsgeschwindigkeit von 8 $\mu$m/h und einem Argondruck von 0,8 Pa wurden 5 $\mu$m dicke Schichten auf den in der Tabelle aufgeführten Hartmetallsubstraten hergestellt.

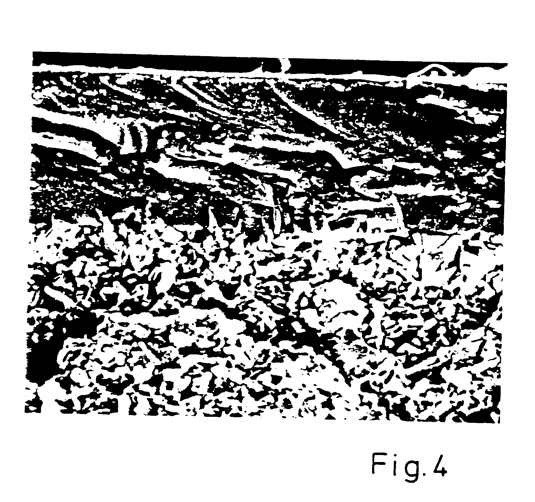

Fig. 4 zeigt die Mikrostruktur der erhaltenen Schichten. Die röntgenographische Untersuchung ergab bei einer Abscheidetemperatur von 200° C sehr breite Beugungsreflexe, die den 111-und 200-Reflexen der kubisch-flächenzentrierten Struktur zuzuordnen sind. Die Schichten aus dem metastabilen Schichtmaterial $(Ti_{0,5}Si_{0,5})C$ mit kubisch-flächenzentrierter Struktur zeigen eine ausgezeichnete Haftung auf Hartmetallsubstraten, hohe Härte ( 2700 $HV_{0,05}$), gute Oxidationsbeständigkeit und hohen Rißausbreitungswiderstand.

Beispiel 2

Durch Magnetron-Abstäuben von einer TiN/SiC-Kathode (hergestellt durch Heißpressen bei 1900° C) mit einer Flächenleistung von 11 W/cm$^2$, einer Schichtwachstumsgeschwindigkeit von 5 $\mu$m/h und einem Argondruck von 0,8 Pa-wurden 5 $\mu$m dicke Schichten auf Hartmetallsubstraten hergestellt.

Auch diese Schichten zeigen verbesserte Oxidationsbeständigkeit, gute Haftung sowie ein günstiges Härte/Zähigkeitsverhältnis.

Die folgende Tabelle zeigt eine Zusammenstellung von Substratmaterialien, die erfindungsgemäß mit TiC/SiC, TiN/SiC, Si$_3$N$_4$/TiC beschichtet wurden.

Die Zusammensetzung der Substrate ist in Gew.-% angegeben.

| | Substratzusammensetzung | | | Durchgeführte Untersuchungen mit den beschichteten Substraten |
|---|---|---|---|---|
| | WC | Co | (Ti,Ta,Nb)C | |
| 1. | 94 | 6 | 0 | Röntgenbeugung |
| 2. | 85,5 | 6 | 8,5 | Schichteigenschaften |
| 3. | 81 | 7 | 12 | Verschleißverhalten |
| 4. | 70 | 10 | 20 | Verschleißverhalten |

**Legende**

Fig. 1: Zustandsdiagramm des ternären Systems Ti-Si-C; errechneter Schnitt TiC-SiC.
Die Flächen bedeuten:
A: Zweiphasengebiet TiC + SiC
B: Zweiphasengebiet TiC + Schmelze
C: Zweiphasengebiet SiC + Schmelze
D: Schmelzphase

Fig. 2: Errechnete freie Bildungsenthalpien (normiert auf G = 0 kJ/mol für die stabilen Gleichgewichtsphasen) für verschiedene (instabile bzw. metastabile) Phasen im System TiC-SiC.
Die Kurven bedeuten:
A: Freie Bildungsenthalpie der kubisch-flächenzentrierten Mischphase
B: Freie Bildungsenthalpie amorphen TiC/SiCMischungen
C: Freie Bildungsenthalpie der hexogonalen (WurtzitTyp) Mischphase
D: Freie Bildungsenthalpie der flüssigen Phase

Fig. 3 PVD-Phasenfelder;
Diagramm Abscheidetemperatur T/Zusammensetzung des Systems TiC-SiC
Die Flächen bedeuten:
A: kubisch-flächenzentrierte (Ti, Si)C-Mischphase
B: amorphe (nanokristalline) (Ti,Si)C-Mischphase
C: hexagonale (Si, Ti)C-Mischphase
D: Zweiphasengebiet; kubisch-flächenzentrierte und hexagonale Mischphase
E: Gleichgewichtsphasen TiC + SiC

Fig. 4: REM-Bild einer Bruchfläche Hartmetallsubstrat + $(Ti_{0,5}Si_{0,5})C$-Schicht
Das Substrat ist in der unteren Bildhälfte dargestellt. Darüber ist die $(Ti_{0,5}Si_{0,5})C$-Schicht erkennbar.

**Patentansprüche**

1. Einlagige oder mehrlagige, jeweils einphasige und vorwiegend kristalline, Titan enthaltende Hartstoff-Schutzschicht mit homogener Elementverteilung für Oberflächen von stark beanspruchten Werkstoff-Substraten, gekennzeichnet durch eine metastabile Mischphase mit einer kubisch-flächenzentrierten Kristallstruktur aus metallischen Hartstoffen und den kovalenten Hartstoffen Siliciumcarbid (SiC) und/oder Siliciumnitrid ($Si_3N_4$).

2. Verfahren zur Herstellung einlagiger oder mehrlagiger, jeweils einphasiger und vorwiegend kristalliner, Titan enthaltender Hartstoff-Schutzschichten nach Anspruch 1, bei dem die physikalische Abscheidung aus der Gasphase (PVD) angewendet wird, dadurch gekennzeichnet, daß die Schutzschicht durch Magnetron-Abstäuben in Argon-Atmosphäre und durch Abschrecken aus der Gasphase auf das Substrat aufgebracht wird, wobei eine Kathode mit der Zusammensetzung der Schutzschicht verwendet wird.

3. Verfahren nach Anspruch 2, dadurch gekennzeichnet, daß die Temperatur des Substrats während der Beschichtung zwischen 200° und 1000° C beträgt.

4. Verfahren zur Herstellung einlagiger oder mehrlagiger, jeweils einphasiger und vorwiegend kristalliner, Titan enthaltender Hartstoff-Schutzschichten nach Anspruch 1, bei dem die physikalische Abscheidung aus der Gasphase (PVD) angewendet wird, dadurch gekennzeichnet, daß metallische Kathoden abge-

5

EP 0 337 007 B1

stäubt werden und die Hartstoff-Schutzschicht durch eine reaktive Gasmischung gebildet wird, wobei die Temperatur des Substrats während der Beschichtung entsprechend der Höhe des Siliciumanteils zwischen 200 und 1000° C gehalten wird.

5.  Verfahren nach Anspruch 4, dadurch gekennzeichnet, daß die relative Gasmischung ein Argon/Stickstoff- und/oder ein Argon/Methan-Gemisch darstellt.

6.  Verfahren nach Anspruch 2 oder 4, dadurch gekennzeichnet, daß während der Beschichtung ein Argon-Ionen-Beschuß des Substrats stattfindet (Bias-Sputtern).

7.  Verfahren nach Anspruch 2, 3, 5 oder 6, dadurch gekennzeichnet, daß der Argon-Druck während der Beschichtung zwischen 0,1 und 2 Pa beträgt.

**Claims**

1.  Single-ply or multiple-ply, in either case single-phase and predominantly crystalline, titanium-containing hard substance protective layer with a homogeneous distribution of elements for surfaces of intensely stressed material substrates, characterised by a metastable mixed phase having a cubic-face-centred crystalline structure formed from metallic hard substances and the covalent hard substances silicon carbide (SiC) and/or silicon nitride ($Si_3N_4$).

2.  Method of producing single-ply or multiple-ply, in either case single-phase and predominantly crystalline, titanium-containing hard substance protective layers according to claim 1, wherein the physical separation from the gas phase (PVD) is employed, characterised in that the protective layer is applied to the substrate by magnetron dusting in an argon atmosphere and by quenching from the gas phase, a cathode being used in combination with the protective layer.

3.  Method according to claim 2, characterised in that the temperature of the substrate during the coating process is between 200° and 1000° C.

4.  Method of producing single-ply or multiple-ply, in either case single-phase and predominantly crystalline, titanium-containing hard substance protective layers according to claim 1, wherein the physical separation from the gas phase (PVD) is employed, characterised in that metallic cathodes are dusted, and the hard substance protective layer is formed by a reactive gas mixture, the temperature of the substrate during the coating process being kept at between 200° and 1000° C, depending on the amount of silicon content.

5.  Method according to claim 4, characterised in that the relative gas mixture comprises a mixture of argon and nitrogen and/or a mixture of argon and methane.

6.  Method according to claim 2 or 4, characterised in that the substrate is bombarded with argon ions during the coating process (bias-sputtering).

7.  Method according to claims 2, 3, 5 or 6, characterised in that the argon pressure during the coating process is between 0.1 and 2 Pa.

**Revendications**

1.  Couche de protection de matériau dur contenant du titane, monocouche ou multicouche, chacune étant monophasée et généralement cristalline, avec une répartition homogène des éléments pour des surfaces de substrats de matériaux soumis à de fortes contraintes, caractérisé par une phase mixte métastable à structure cristalline cubique à faces centrées comprenant des matériaux durs métalliques et des matériaux durs covalents, carbure de silicium (SiC) et/ou nitrure de silicium ($Si_3N_4$).

2.  Procédé de production de couches de protection de matériau dur contenant du titane, monocouche ou multicouche, chacune étant monophasée et généralement cristalline selon la revendication 1, dans lequel on utilise le dépôt physique à partir de la phase gazeuse (PVD), caractérisé en ce qu'on dépose la couche de protection par pulvérisation au magnétron dans une atmosphère d'argon et par trempe à

6

partir de la phase gazeuse sur le substrat, en utilisant une cathode ayant la composition de la couche de protection.

3. Procédé selon la revendlcation 2, caractérisé en ce que la température du substrat pendant le revêtement est située entre 200° et 1000° C.

4. Procédé de production de couches de protection de matériau dur contenant du titane, monocouche ou multicouche, chacune étant monophasée et généralement cristalline, selon la revendication 1, en utilisant le dépôt physique depuis la phase gazeuse (PVD), caractérisé en ce qu'on pulvérise des cathodes métalliques et qu'on forme la couche de protection de matériau dur par un mélange de gaz réactif, la température du substrat pendant le revêtement étant comprise entre 200 et 1000° C en fonction de la teneur en silicium.

5. Procédé selon la revendication 4, caractérisé en ce que le mélange gazeux correspondant est un mélange argon/azote et/ou un mélange argon/méthane.

6. Procédé selon la revendication 2 ou 4, caractérisé en ce que pendant le revêtement il y a un bombardement du substrat par des ions d'argon (pulvérisation Bias).

7. Procédé selon la revendication 2, 3, 5 ou 6, caractérisé en ce que la pression d'argon pendant le revêtement est comprise entre 0,1 et 2 Pa.

Fig. 1

Fig. 2

Fig. 4